# EUROPEAN PATENT APPLICATION

(11) **EP 2 200 183 A2**
(43) Date of publication of application: **23.06.2010**
(21) Application number: 09152931.3
(22) Date of filing: 16.02.2009
(51) Int. Cl.: H04B 1/04

(54) **Reducing power consumption of WiMAX Customer Premises Equipment (CPE)**

(30) Priority: 16.12.2008 IN DE28462008
(71) Applicant: C-DOT Alcatel-Lucent Research center Private Limited, 110030 New-Dehli (IN)
(72) Inventor: Krishnaswami, Sheela M435/15 Royal Enclave, 600041, CHENNAI, TAMINADU (IN); Sethuraman, Venkataraman 9/1, FF, `C , Presidency heritage, 600041, CHENNAI, TAMINADU (IN); Arshad, Saleem Sai Akhil, Flat no. 6, FF, No.4, 4th cross street, 600041, CHENNAI, TAMINADU (IN)
(74) Representative: Sciaux, Edmond

(57) **Abstract**

The present invention relates to methods for producing variants of a parent JP170 subtilase and of a parent BPN' subtilase and to JP170 and BPN' variants having altered properties as compared to the parent JP170/BPN' subtilases.

## Description

### BACKGROUND

### Technical Field

The embodiments herein generally relate to wireless communication, and more particularly to, power conserving functions in wireless communications.

### Description of the Related Art

Generally signal processing, transmitting and processing circuitries for high frequency modulated data signals require substantial amounts of power. In a typical WiMAX communication system, a WiMAX hub Base Station Transceiver system (BTS) communicates with a plurality of remotely located Customer Premises Equipments (CPEs).
The CPE allows users within a building, for example, to communicate over-the-air interface between the CPE and WiMAX BTS. A WiMAX CPE typically comprises multi-stage power amplifiers. The WiMAX technology supports wide range of transmitted output powers of the CPE's through dynamic power control. It also supports different modulation and coding schemes that are adapted based on the channel quality. In order to have low power consumption and also avoid non-linear operation of PA, it is desirable to have proper control biasing of the PA.

Previously, techniques have been employed to ensure linearity of the PA by either fixing it to the highest bias point or varying the control bias of the PA depending on transmitted power level. These techniques are usually sufficient as the modulation and coding rates are fixed.

Most of the portable Customer Premises Equipments (CPEs) are battery operated and the battery induces a limit on the consumption of DC power. The PAs require significantly high DC power input regardless of the power transmitted by the CPE's depending on the control bias level. Based on the efficiency of the power amplifier, the consumed excessive DC power has to be dissipated in the form of heat. Thus lesser efficient power amplifiers consume more current thereby reducing the battery life. Further about 50% of the time, the CPE's transmitted power range is between 7-17dBm. In this scenario, the CPE power consumption is expected to be lesser. But, in reality, the CPE's consume high DC power owing to higher control bias of the PA.

High operating current of CPES leads to dissipation of excessive heat. This results in reduced reliability of the key PA component, which in turn reduces the reliability of the product itself.

In conventional methods, the bias current is fixed at maximum value to meet linearity requirements which in turn results in decreasing the efficiency of the PA. Further, by constant biasing of the PA to highest point, which is used mainly to meet the linearity requirement for highest supported modulation schemes for maximum supported output power, leads to unnecessary wastage of DC power. In other conventional methods, the bias is varied depending on the transmitted power level of the PA. This results in improving the efficiency of the PA, but may not meet the linearity requirements, when the modulation and coding is varied, as is the case for WiMAX system.

### SUMMARY

In view of the foregoing, an embodiment herein provides a method of reducing power consumption of Power Amplifiers (PA) in wireless communication systems. This is done by biasing the PA adaptively for different power levels and MCS.

Embodiments herein disclose a method of reducing power consumption of Power Amplifiers (PA) in wireless communication systems, the method comprising steps of: identification of stages of the power amplifiers, wherein the stages consume maximum power. ; Determination of corresponding bias voltages of the stage(s) of the power amplifiers; checking Error Vector Magnitude (EVM) for present bias and present input signal power levels of the power amplifiers; determining optimal bias voltage for the required modulation and coding scheme for the power amplifiers; and biasing the power amplifier with the optimal bias voltage. The step of determining optimal bias voltage for required Modulation and Coding Scheme(MCS) for the power amplifiers further comprising steps of evaluating the EVM values for the present bias and the input signal power level; comparing the evaluated EVM values with required values for present modulation and coding scheme (MCS); checking if the evaluated EVM value is within specified range of values for given modulation and coding scheme; and calculating the optimal biasing voltage if the evaluated EVM value is not within the required range. The mathematical model can be modeled using mathematical equations through curve fitting and the mathematical model evaluates the EVM values for one of the input signal power levels to the power amplifier; and modulation and coding schemes at different biasing points. The step of determining optimal bias voltage for required modulation and coding scheme for the power amplifiers further comprises steps of preparing the optimum bias voltage table for the power amplifier; loading look up tables to memory; and looking up the optimal bias voltage values for the modulation and coding scheme and the present signal power level for corresponding the EVM.

The optimal bias for the PA can be determined by two methods., either using a mathematical model of the PA or a look-up table of optimal bias values

The first method comprises of steps of checking Error Vector Magnitude (EVM) for present bias and present input signal power levels of the power amplifiers, determining optimal bias voltage for required modulation and coding scheme (MCS) and biasing the power amplifier with the optimal bias voltage. The method of determining optimal bias voltage for power amplifiers comprises of evaluating the EVM values for the present bias and the present input signal power level, and comparing the evaluated EVM values with required values for present modulation and coding scheme, checking if the evaluated EVM value is within the required range for that modulation and coding scheme and determining the optimal biasing voltage if the evaluated EVM value is not within the required range. The mathematical model can be obtained using mathematical equations through curve fitting. The mathematical model provides EVM values for different input signal power levels to the power amplifier, modulation and coding schemes at different biasing points.

The second method of calculating optimal bias voltage for power amplifiers comprises of preparing the optimum bias voltage table for the power amplifier, loading the look up tables to memory, and looking up the optimal bias values for the required modulation and coding scheme (MCS) and the present signal power level

Embodiments herein further disclose a system for reducing power consumption of power amplifiers in wireless communication systems. The system comprises of an identification means to identify stages of the power amplifiers, wherein the stages consume maximum power.; a first determination means to determine (202) corresponding bias voltages of the stage(s) of the power amplifiers; an evaluation means to evaluate Error Vector Magnitude (EVM) for present bias and signal power level of the power amplifiers, a determination means to determine optimal bias voltage for present modulation and coding scheme (MCS), and a biasing means to bias the power amplifier with the optimal bias voltage. The determination means comprising of a measuring means to measure the EVM values for the different bias and the input signal power level, a comparing means to compare the evaluated EVM values with required values for present modulation range, a checking means to check if the evaluated EVM value is within the required values for the modulation range, and a calculating means to calculate the optimal biasing voltage if the evaluated EVM value is not within the required modulation and coding scheme (MCS). The determining means is used to evaluate optimal the EVM values for various input signal power levels to the power amplifier, modulation and coding schemes at various biasing points. The evaluation means further comprising of a preparation means to prepare the optimum bias voltage table for the power amplifier, a loading means to load the look up tables into a memory, and a looking up means to look for the optimal bias corresponding to the present signal power level and modulation and coding scheme (MCS) in the look up table.

These and other aspects of the embodiments herein will be better appreciated and understood when considered in conjunction with the following description and the accompanying drawings.

### BRIEF DESCRIPTION OF THE DRAWINGS

The embodiments herein will be better understood from the following detailed description with reference to the drawings, in which:

FIG. 1 is a general block diagram illustrating a Power Amplifier(PA) with adaptive biasing, for WiMAX (Worldwide Interoperability for Microwave Access) Customer Premises Equipment (CPE), in accordance with the embodiments herein;

FIG. 2 illustrates a flow chart depicting a method for determining the bias to be applied to the PA, in accordance with the embodiments herein;

FIG. 3 is a block diagram illustrating the adaptive PA bias circuit using a look up table, in accordance with the embodiments herein;

FIG. 4 illustrates a flow chart depicting a method for dynamic variation of bias voltage using the look up table, in accordance with the embodiments herein;

FIG. 5 is a block diagram illustrating the circuit used to evaluate the PA, in accordance with the embodiments herein;

FIG. 6 is a block diagram illustrating the adaptive PA bias circuit using mathematical bias determination; in accordance with the embodiments herein;

FIG. 7 illustrates a flow chart depicting a method for the mathematical calculation of bias voltage, in accordance with the embodiments herein;

FIG. 8 is a graph illustrating the variation of EVM with PA Radio Frequency (RF) input power at different biasing points for 64 Quadrature Amplitude Modulation (QAM), in accordance with the embodiments herein;

FIG. 9 is a graph illustrating the variation of EVM with PA RF input power at different biasing points for 16QAM, in accordance with the embodiments herein;

FIG. 10 is a graph illustrating the variation of EVM with PA RF input power at different biasing points for Quadrature Phase-shift Keying (QPSK), in accordance with the embodiments herein;

FIG. 11 is a graph illustrating the variation of Output Power with PA RF input power at different biasing points for 64QAM, in accordance with the embodiments herein

FIG. 12 is a graph illustrating the variation of PA RF Output Power with PA RF input power at different biasing points for 16QAM modulation, in accordance with the embodiments herein;

FIG. 13 is a graph illustrating the variation of PA RF Output Power with PA RF input power at different biasing points for QPSK modulation, in accordance with the embodiments herein;

FIG. 14 is a graph illustrating the variation of Gain of PA with PA RF input power at different biasing points for 64QAM, in accordance with the embodiments herein;

FIG. 15 is a graph illustrating the variation of Gain of PA with PA RF input power at different biasing points for 16QAM modulation, in accordance with the embodiments herein;

FIG. 16 is a graph illustrating the variation of Gain of PA with PA RF input power at different biasing points for QPSK modulation, in accordance with the embodiments herein;

FIG. 17 is a graph illustrating the variation of DC Current Consumption with PA RF input power at different biasing points for 64QAM modulation, in accordance with the embodiments herein;

FIG. 18 is a graph illustrating the variation of DC Current Consumption with PA RF input power at different biasing points for 16QAM modulation, in accordance with the embodiments herein; and

FIG. 19 is a graph illustrating the variation of DC Current Consumption with PA RF input power at different biasing points for QPSK modulation, in accordance with the embodiments herein.

### DETAILED DESCRIPTION OF EMBODIMENTS

The embodiments herein and the various features and advantageous details thereof are explained more fully with reference to the non-limiting embodiments that are illustrated in the accompanying drawings and detailed in the following description. Descriptions of well-known components and processing techniques are omitted so as to not unnecessarily obscure the embodiments herein. The examples used herein are intended merely to facilitate an understanding of ways in which the embodiments herein may be practiced and to further enable those of skill in the art to practice the embodiments herein. Accordingly, the examples should not be construed as limiting the scope of the embodiments herein.

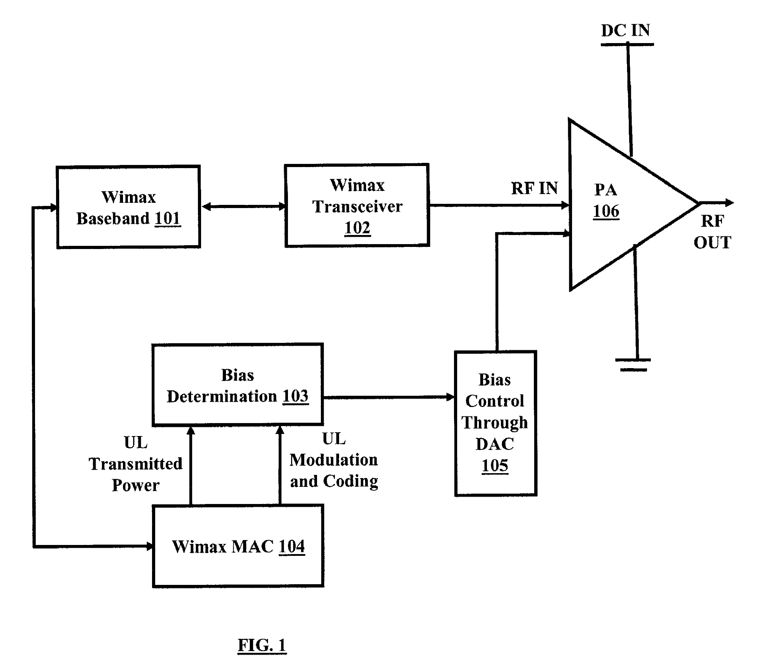

The embodiments herein achieve a method for adaptively biasing the Power Amplifier (PA) in Worldwide Interoperability for Microwave Access (WiMAX) Customer Premises Equipment (CPE) by taking into account the signal's linearity requirement through Error Vector Magnitude (EVM) with a variation in the modulation of the signal and a variation in the coding rates of the signal along with a variation in the input signal power level. Referring now to the drawings, and more particularly to FIGS. 1 through 19, where similar reference characters denote corresponding features consistently throughout the figures, there are shown embodiments.

The linearity requirement of the PA is different for different signal modulation and coding rates and these requirements for WiMAX are specified as the EVM by the Institute of Electrical and Electronic Engineers (IEEE). The embodiment herein discloses a method of adaptively biasing the PA in WiMAX CPE by taking into consideration the variation of EVM with a variation in input signal power level, variation in the scheme used to modulate the signal and a variation in the coding rates of the signal. By adaptively biasing the PA, the DC power consumption of the PA can be reduced.

FIG. 1 is a general block diagram illustrating a Power Amplifier (PA) with adaptive biasing, for WiMAX (Worldwide Interoperability for Microwave Access) Customer Premises Equipment (CPE), in accordance with the embodiments herein. The circuit comprises a WiMAX Medium Access Control (MAC) 104, a WiMAX baseband IC 101, a WiMAX transceiver 102, a Bias determination block 103, a Bias control through Digital to Analog Converter (DAC) 105 and a PA 106.The WiMAX Medium Access Control (MAC) 104 provides data and control signals to the WiMAX baseband IC 101,which carries out necessary WiMAX physical layer functions and produces a transmit baseband signal Physical layer functions include the type of modulation scheme used to modulate the signal and coding done to the signal transmitted. The WiMAX transceiver 102, which is usually a separate circuit, controls the RF functionalities which include up-conversion and amplification of the signal received from the said WiMAX baseband IC. The WiMAX transceiver 102 may also contain circuits for gain control for controlling its output signal power level. The Bias determination block 103 determines the bias to be applied to the PA 106 by taking into consideration the modulation and coding scheme (MCS) and the signal power level. The Bias determination block 103 through DAC 105 controls the bias applied to the PA 106. The PA 106 amplifies the power of the signal input from the WiMAX transceiver. The PA 106 is biased through DAC 105 and the input RF signal to the PA 106 is obtained from the WiMAX transceiver 102.

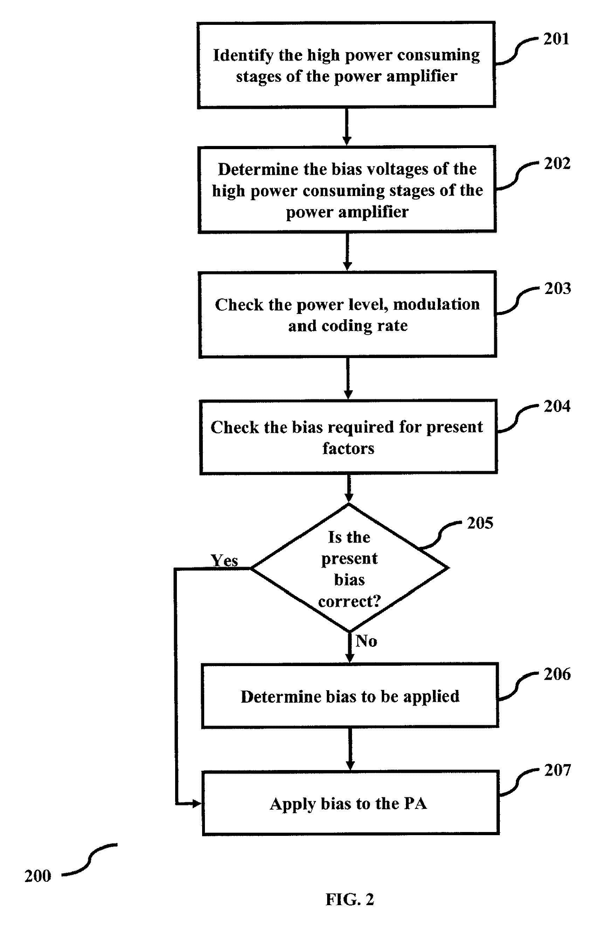

FIG. 2 illustrates a flow chart depicting a method for bias determination to be applied to the PA, in accordance with the embodiments herein. The Power Amplifier 106 is evaluated for its Error Vector Magnitude (EVM) performance or the non-linear behavior is modeled a priori to obtain the optimal level of bias for the power amplifier 106. WiMAX supports various modulation and coding scheme (MCS) which can be adapted to the channel quality. The stages of the power amplifier which consume higher power as compared to the other stages of the power amplifier are identified (201) and the bias voltages of those stages are determined (202). The current input power level of the PA, modulation and coding rates are checked (203). Then, the bias required for the measured factors are checked (204). A check is made (205) if the present bias is the required bias. If the present bias and the required bias match, then the bias is applied (207) to the PA 106. If the present bias and the required bias do not match, then the bias to be applied to the PA 106 is determined (206) and the bias is applied (207) to the PA. The various actions in method 200 may be performed in the order presented, in a different order or simultaneously. Further, in some embodiments, some actions listed in FIG. 2 may be omitted.

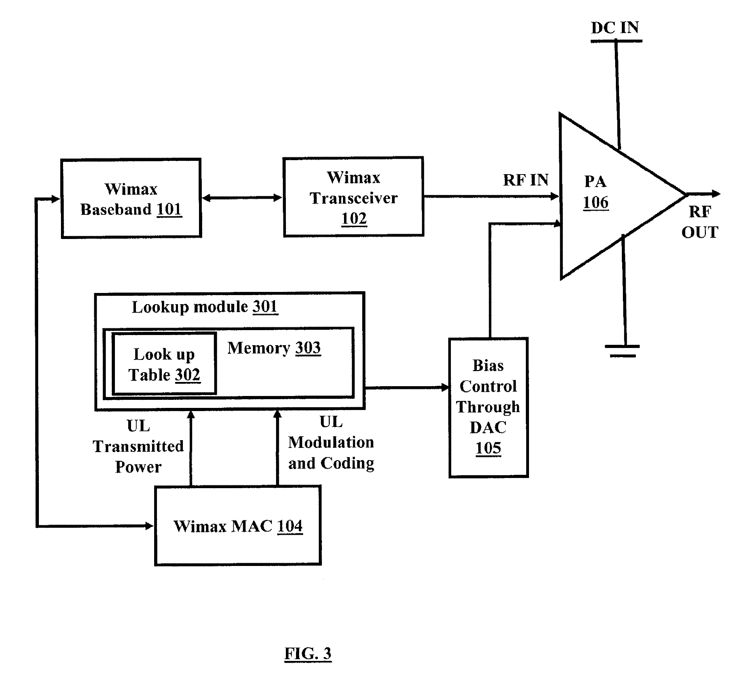

FIG. 3 is a block diagram illustrating the adaptive PA bias circuit using a look up table, in accordance with the embodiments herein. The circuit comprises a WiMAX MAC 104, WiMAX baseband IC 101, WiMAX transceiver 102, a look up module 301, Bias control through Digital to Analog Converter (DAC) 105 and PA 106. The WiMAX (MAC) 104 provides data and control signals to the WiMAX baseband IC 101 which produces a baseband signal. Physical layer functions include the type of modulation scheme used to modulate the signal and coding done to the signal. The WiMAX transceiver 102, which is usually a separate circuit, controls the RF functionalities and the RF functionalities include up-conversion and amplification of the signal. The WiMAX transceiver 102 may also contain circuits for gain control for controlling the signal level at its output. The look up module 301 determines the bias to be applied to the PA 106 by taking into consideration the modulation and coding scheme (MCS) used and the signal power level. The look up module 301 comprises a table of optimum bias voltages that can be applied to the PA 106. The look up table 302 is present in memory 303. The look up table 302 can be prepared a priori either manually or in an automated fashion for different input power levels, different modulation schemes and coding rates and is prepared by evaluating the PA 106. The evaluation of the PA 106 takes into consideration the variation of EVM for different modulation and coding schemes (MCS) used and different input power levels of the signal. The PA 106 is evaluated and the EVM performance of the PA 106 is modeled and a set of optimal bias voltages are stored in the memory 303 of the WiMAX CPE as a look up table 302 in the look up module 301. The method checks the modulation and coding scheme (MCS) used and the input signal power level. The method then checks the look up table 302 for the value of the bias to be applied to the PA 106 for the corresponding modulation scheme, signal coding and input signal power level. The bias value obtained by looking up the look up table 302 is the optimum bias to be applied to the PA 106. The Bias control through (Digital to Analog Converter) DAC (105) controls the bias voltage applied to the PA 106 by taking the value of the bias determined from the look up table 302 and applying this value to the PA 106. The input signal to the PA 106 is obtained from the WiMAX transceiver (102). Table 1 shows an exemplary look up table 302. The number of entries in Table 1 may depend on the number of modulation schemes used and the number of coding rates supported

**Table 1**

| **Pin (dBm)** | **64QAM -3/4** | **64QAM-2/3** | **64QAM-1/2** | **16QAM-3/4** | **16QAM-1/2** | **QPSK-3/4** | **QPSK-1/2** |
|---|---|---|---|---|---|---|---|
| **P1** | Optim bias | Optim bias | Optim bias | Optim bias | Optim bias | Optim bias | Optim bias |
| **P2** | Optim bias | Optim bias | Optim bias | Optim bias | Optim bias | Optim bias | Optim bias |
| **:** | | | | | | | |
| **:** | | | | | | | |
| **P(n-1)** | Optim bias | Optim bias | Optim bias | Optim bias | Optim bias | Optim bias | Optim bias |
| **Pn** | Optim bias | Optim bias | Optim bias | Optim bias | Optim bias | Optim bias | Optim bias |

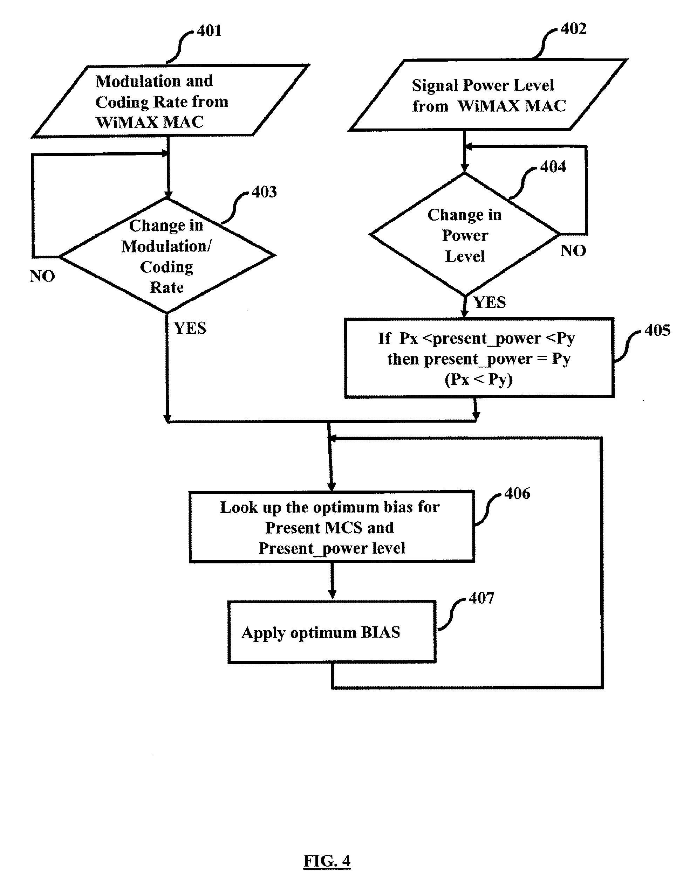

FIG. 4 illustrates a flow chart depicting a method for the calculation of Error Voltage Magnitude (EVM) and bias voltage using the look up table 302, in accordance with the embodiments herein. The Power Amplifier 106 is evaluated for its Error Vector Magnitude (EVM) performance or the non-linear behavior is modeled a priori to obtain the optimal level of bias for the power amplifier 106. Initially the Power Amplifier (106) is initialized to the highest biasing point. A check is made (401) to detect any change (403) in the modulation scheme or the coding rate. Further the signal power level is checked (402) to detect any change (404) in the power level of the signal. In case there is a change in the signal power level and/or MCS, the values are fed to the look up module 301. If the present signal power level is between the two successive power level entries Px and Py for any MCS, (where Py is greater than Px), in the look up table 302, then the look up module 301 sets the present signal power level to Py 405. Now the look up module 301 looks up (410) for the optimum bias required for the present signal power level and MCS in the look-up table Further the determined bias is applied (407) to the power amplifier 106. The various actions in method 400 may be performed in the order presented, in a different order or simultaneously. Further, in some embodiments, some actions listed in FIG. 4 may be omitted.

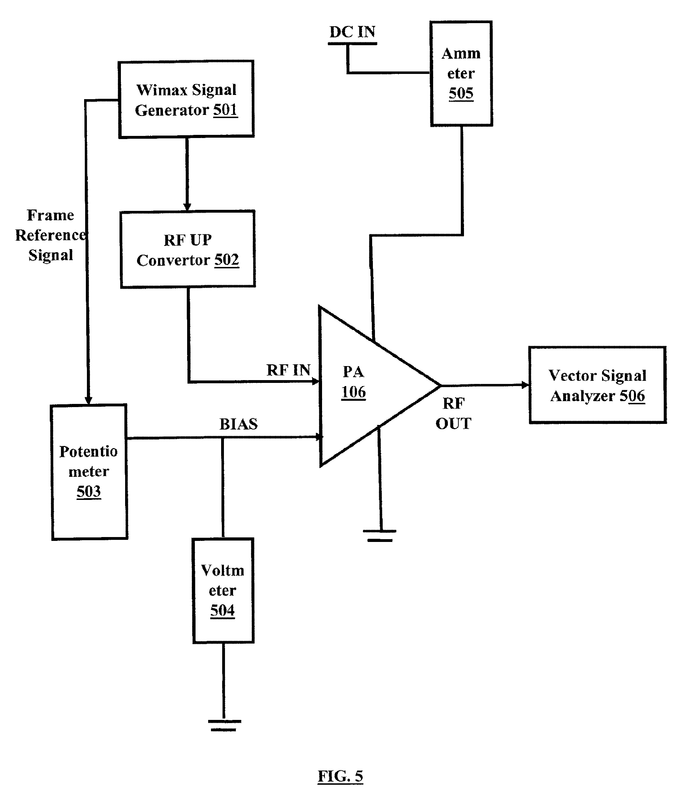

FIG. 5 is a block diagram illustrating the set-up used to evaluate the PA in accordance with the embodiments herein. The set-up comprises a WiMAX signal generator 501, RF UP converter 502, potentiometer 503, voltmeter 504, ammeter 505, Vector Signal Analyzer 506 and PA 106. The WiMAX signal generator 501 generates the signals of various modulations and coding. Also, it generates frame reference signal meant for enabling PA only during uplink portion of the WiMAX frame. RF UP converter 502 converts the signal of a particular frequency to a signal of a higher frequency. The potentiometer 503 adjusts the voltage level of the signal obtained from the WiMAX signal generator 501 and passes the voltage- adjusted signal as an input to biasing pin of the PA 106. The voltmeter 504 measures the voltage level of the bias to the PA 106 and the ammeter 505 measures the value of the input DC current to the PA 106. Vector Signal Analyzer 506 analyses the spectral composition and the power spectrum of the RF output signal from the PA 106. The vector signal analyzer 506 also performs digital demodulation functions on the RF output signal. Table 2 shows different parameters of the signal at which readings were taken.

**Table 2**

| **Number** | **Parameter** | **Value** |
|---|---|---|
| 1 | Center Frequency | 2.5 GHz |
| 2 | Bandwidth | 10 MHz |
| 3 | Frame Size | 5 ms |
| 4 | DL:UL Ratio | 67:33 |
| 5 | Temperature | Ambient Room Temperature |

EVM (dB), the output power (Pout) (dBm), the current (Id3) (mA), Gain (dB) and Efficiency (%) were measured for different modulation schemes. Table 3 shows the EVM (dB) for 64QAM-3/4.

**Table 3**

| **Pin (dBm)** | **Vpc3 = 3.1** | **Vpc3 = 3.0** | **Vpc3 = 2.9** | **Vpc3 = 2.8** | **Vpc3 = 2.7** | **Vpc3 = 2.6** | **Vpc3 = 2.5** | **Vpc3 = 2.4** |
|---|---|---|---|---|---|---|---|---|
| -63 | -32.82 | -32.72 | -32.72 | -32.87 | -32.86 | -32.76 | -31.89 | -23.69 |
| -58 | -37.51 | -37.56 | -37.58 | -37.56 | -37.45 | -37.22 | -36.23 | -28.88 |
| -53 | -42.07 | -42.02 | -42.06 | -41.71 | -41.43 | -40.96 | -39.39 | -33.61 |
| -48 | -45.46 | -45.38 | -45.22 | -45 | -44.25 | -43.41 | -40.99 | -37.23 |
| -43 | -47.66 | -47.91 | -47.56 | -46.52 | -45.93 | -44.6 | -40.01 | -37.8 |
| -38 | -48 | -48.89 | -48.39 | -47.46 | -46.23 | -44.3 | -34.58 | -31.59 |
| -33 | -48.92 | -49.2 | -48.58 | -47.18 | -46.02 | -40.76 | -23.47 | -22.11 |
| -28 | -49.09 | -48.45 | -48.46 | -47.45 | -44.12 | -33.38 | -19.45 | -16.59 |
| -23 | -48.22 | -47.4 | -47.11 | -43.86 | -34.65 | -23.37 | -16.95 | -13.21 |
| -18 | -46.91 | -44.13 | -35.5 | -27.26 | -20.79 | -18.64 | -16.05 | -13.38 |
| -13 | -30.77 | -25.87 | -22.3 | -19.73 | -18.35 | -17.42 | -16.01 | -14.5 |
| -10 | -26.41 | -23.5 | -20.58 | -18.97 | -17.72 | -16.56 | -15.39 | |
| -9 | -23.87 | -21.58 | -19.7 | -18.2 | -17.31 | -16.29 | -15.27 | |

Table 4 shows the Pout (dBm) for 64QAM-3/4.

**Table 4**

| **Pin (dBm)** | **Vpc3 = 3.1** | **Vpc3 = 3.0** | **Vpc3 = 2.9** | **Vpc3 = 2.8** | **Vpc3 = 2.7** | **Vpc3 = 2.6** | **Vpc3 = 2.5** | **Vpc3 = 2.4** |
|---|---|---|---|---|---|---|---|---|
| -63 | -29.4 | -29.6 | -29.8 | -30.2 | -30.92 | -32.38 | -40.51 | -55.56 |
| -58 | -24.48 | -24.63 | -24.81 | -25.22 | -25.96 | -27.97 | -34.71 | -50.75 |
| -53 | -19.49 | -19.61 | -19.84 | -20.23 | -21 | -22.64 | -29.96 | -45.57 |
| -48 | -14.23 | -14.48 | -14.66 | -15.04 | -15.76 | -17.56 | -24.61 | -40.4 |
| -43 | -9.26 | -9.44 | -9.65 | -10.02 | -10.79 | -12.3 | -19.65 | -35.42 |
| -38 | -4.21 | -4.42 | -4.65 | -5.03 | -5.77 | -7.41 | -14.12 | -30.34 |
| -33 | 0.814 | 0.64 | 0.41 | 0.02 | -0.72 | -2.5 | -12.25 | -25.27 |
| -28 | 5.71 | 5.54 | 5.32 | 4.96 | 4.27 | 2.55 | -4.83 | -17.63 |
| -23 | 10.81 | 10.59 | 10.38 | 9.97 | 9.17 | 7.49 | 1.49 | -7.33 |
| -18 | 15.78 | 15.62 | 15.39 | 14.85 | 13.56 | 11.92 | 8.14 | 3.09 |
| -13 | 20.69 | 20.33 | 19.96 | 19.1 | 17.8 | 16.41 | 13.88 | 10.99 |
| -10 | 22.63 | 22.4 | 21.81 | 21.04 | 19.72 | 17.93 | 15.7 | |
| -9 | 23.68 | 23.54 | 23.15 | 22.58 | 21.59 | 20.4 | 18.78 | 16.69 |

Table 5 shows the Id3 (mA) for 64QAM-3/4.

**Table 5**

| **Pin (dBm)** | **Vpc3 = 3.1** | **Vpc3 = 3.0** | **Vpc3 = 2.9** | **Vpc3 = 2.8** | **Vpc3 = 2.7** | **Vpc3 = 2.6** | **Vpc3 = 2.5** | **Vpc3 = 2.4** |
|---|---|---|---|---|---|---|---|---|
| -63 | 194.8 | 152.1 | 111.1 | 69.2 | 39.4 | 19.6 | 3.4 | 0.6 |
| -58 | 198 | 151.5 | 111.1 | 68.5 | 38.8 | 17.4 | 3.8 | 0.5 |
| -53 | 197.3 | 156.8 | 111.2 | 69.3 | 38.8 | 18.2 | 3.7 | 0.6 |
| -48 | 197.2 | 152 | 111 | 69.3 | 39.7 | 18.4 | 4 | 0.6 |
| -43 | 197.4 | 156.8 | 110.9 | 70.9 | 38.7 | 18.9 | 3.8 | 0.5 |
| -38 | 198.2 | 153.2 | 111.1 | 69.5 | 38.9 | 17.9 | 4.1 | 0.6 |
| -33 | 195.6 | 152.4 | 107.4 | 68.4 | 38.7 | 17.1 | 2.7 | 0.5 |
| -28 | 195 | 151.4 | 107.6 | 68.6 | 40 | 18.6 | 4.2 | 0.7 |
| -23 | 194.4 | 152.1 | 109.2 | 69.9 | 40.7 | 22.1 | 6.4 | 1.6 |
| -18 | 198.1 | 152.9 | 109.7 | 72.8 | 42.2 | 27.5 | 12.8 | 5.5 |
| -13 | 199.2 | 156.5 | 118.9 | 81.8 | 55.4 | 40.9 | 25.5 | 15.2 |
| -10 | 199.8 | 169.9 | 126 | 95 | 67.7 | 47.3 | 31.8 | |
| -9 | 200 | 164.9 | 128.5 | 93.8 | 71.1 | 51.9 | 36.2 | |

Table 6 shows the Gain (dB) for 64QAM-3/4.

**Table 6**

| **Pin (dBm)** | **Vpc3 = 3.1** | **Vpc3 = 3.0** | **Vpc3 = 2.9** | **Vpc3 = 2.8** | **Vpc3 = 2.7** | **Vpc3 = 2.6** | **Vpc3 = 2.5** | **Vpc3 = 2.4** |
|---|---|---|---|---|---|---|---|---|
| -63 | 33.6 | 33.4 | 33.2 | 32.8 | 32.08 | 30.62 | 22.49 | 7.44 |
| -58 | 33.52 | 33.37 | 33.19 | 32.78 | 32.04 | 30.03 | 23.29 | 7.25 |
| -53 | 33.51 | 33.39 | 33.16 | 32.77 | 32 | 30.36 | 23.04 | 7.43 |
| -48 | 33.77 | 33.52 | 33.34 | 32.96 | 32.24 | 30.44 | 23.39 | 7.6 |
| -43 | 33.74 | 33.56 | 33.35 | 32.98 | 32.21 | 30.7 | 23.35 | 7.58 |
| -38 | 33.79 | 33.58 | 33.35 | 32.97 | 32.23 | 30.59 | 23.88 | 7.66 |
| -33 | 33.814 | 33.64 | 33.41 | 33.02 | 32.28 | 30.5 | 20.75 | 7.73 |
| -28 | 33.71 | 33.54 | 33.32 | 32.96 | 32.27 | 30.55 | 23.17 | 10.37 |
| -23 | 33.81 | 33.59 | 33.38 | 32.97 | 32.17 | 30.49 | 24.49 | 15.67 |
| -18 | 33.78 | 33.62 | 33.39 | 32.85 | 31.56 | 29.92 | 26.14 | 21.09 |
| -13 | 33.69 | 33.33 | 32.96 | 32.1 | 30.8 | 29.41 | 26.88 | 23.99 |
| -10 | 32.63 | 32.4 | 31.81 | 31.04 | 29.72 | 27.93 | 25.7 | |
| -9 | 32.68 | 32.54 | 32.15 | 31.58 | 30.59 | 29.4 | 27.78 | 25.69 |

Table 7 shows the Efficiency (%) for 64QAM-3/4.

**Table 7**

| **Pin (dBm)** | **Vpc3 = 3.1** | **Vpc3 = 3.0** | **Vpc3 = 2.9** | **Vpc3 = 2.8** | **Vpc3 = 2.7** | **Vpc3 = 2.6** | **Vpc3 = 2.5** | **Vpc3 = 2.4** |
|---|---|---|---|---|---|---|---|---|
| -63 | 8.15E-05 | 9.5131E-05 | 0.0001 | 0.0001 | 0.0001 | 0.0001 | 3.415E-05 | 1.141E-06 |
| -58 | 0.000249 | 0.0002997 | 0.0003 | 0.0004 | 0.0005 | 0.0004 | 0.0001286 | 3.463E-06 |
| -53 | 0.000789 | 0.0009264 | 0.0011 | 0.0014 | 0.0016 | 0.0015 | 0.0003849 | 1.138E-05 |
| -48 | 0.002653 | 0.0030941 | 0.0037 | 0.0047 | 0.0055 | 0.0050 | 0.0013104 | 3.744E-05 |
| -43 | 0.008324 | 0.0096343 | 0.0119 | 0.0149 | 0.0176 | 0.0166 | 0.0041245 | 0.000118 |
| -38 | 0.026540 | 0.0311775 | 0.0378 | 0.0478 | 0.0559 | 0.0522 | 0.0146356 | 0.000379 |
| -33 | 0.085324 | 0.1003791 | 0.1242 | 0.1544 | 0.1794 | 0.1641 | 0.0232499 | 0.001222 |
| -28 | 0.264107 | 0.3118220 | 0.3843 | 0.4808 | 0.5568 | 0.5116 | 0.1240014 | 0.007067 |
| -23 | 0.856823 | 0.9938512 | 1.2192 | 1.5060 | 1.7059 | 1.5057 | 0.5062101 | 0.074089 |
| -18 | 2.649045 | 3.1514942 | 3.8514 | 4.5137 | 4.6023 | 3.8418 | 2.0569078 | 0.746169 |
| -13 | 8.167470 | 9.1513716 | 10.392 | 11.122 | 10.526 | 9.0136 | 6.2173805 | 3.792361 |
| -10 | 12.73501 | 13.798640 | 15.231 | 15.686 | 14.508 | 11.853 | 8.6243089 | |
| -9 | 16.20457 | 18.378361 | 20.429 | 22.562 | 21.633 | 19.885 | 16.515578 | |

Table 8 gives the EVM requirements provided by the section 8.4.12.3 of IEEE 802.16e-2005 for WiMAX.

**Table 8**

| **Relative Constellation Error** | |
|---|---|
| QPSK - ½ | -15dB |
| QPSK -3/4 | -18dB |
| 16-QAM -1/2 | -20.5dB |
| 16-QAM -3/4 | -24dB |
| 64-QAM -1/2 | -26dB |
| 64-QAM -2/3 | -28dB |
| 64-QAM -3/4 | -30dB |

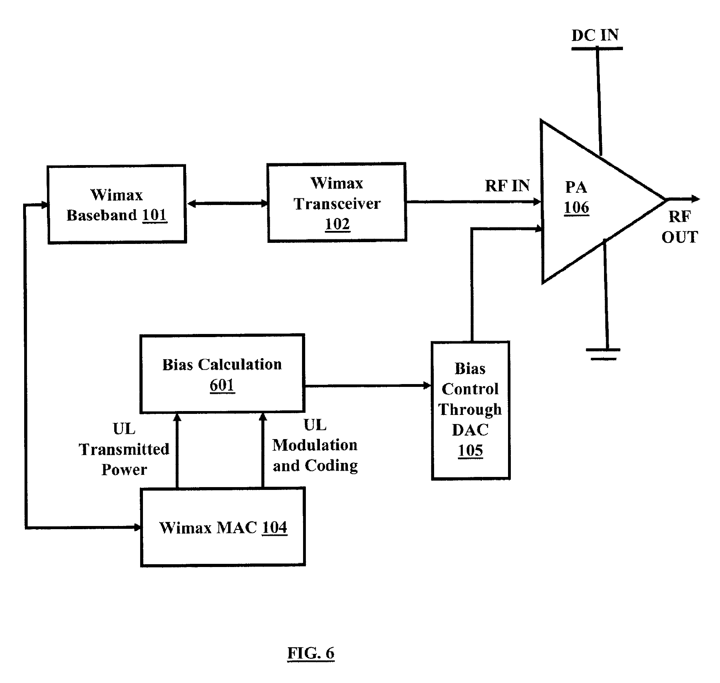

FIG. 6 is a block diagram illustrating the adaptive PA bias circuit using mathematical bias determination; in accordance with the embodiments herein. The circuit comprises a WiMAX stack 104, a WiMAX baseband IC 101, a WiMAX transceiver 102, a bias calculation block 601, a Bias control through Digital to Analog Converter (DAC) 105 and PA 106. The WiMAX (MAC) 104 provides data and control signals to the WiMAX baseband IC 101 which produces a baseband signal and carries out physical layer functions such as the type of modulation scheme used to modulate the signal and coding done to the signal. The WiMAX transceiver 102 which is usually a separate circuit controls the RF functionalities and the RF functionalities may include up-conversion and amplification of the signal. The WiMAX transceiver 102 may also contain circuits for gain control for controlling the signal level at its output. The Bias Calculation block 601 determines the bias to be applied to the PA 106 by taking into consideration the modulation and coding scheme (MCS) used and the signal power level. The bias calculation block 601 determines the bias to be applied to the PA 106 by mathematical equations through curve fitting. The model considers the modulation and coding scheme (MCS) used and the input signal power level. The model determines the EVM for the present bias applied to the PA 106 and compares the determined EVM to the required range of EVM for the present modulation, coding rate and input signal power level. If the determined EVM is equal to the required range of EVM for the present modulation, coding rate and input signal power level then the calculated bias is applied to the PA 106. If the determined EVM is lesser than the required range of EVM for the present modulation, coding rate and input signal power level then a bias value is subtracted from the present bias value to make the bias value equal to the optimum bias value. The calculated bias is the bias to be applied to the PA 106. If the determined EVM is greater than the required range of EVM for the present modulation, coding rate and input signal power level then a bias value is added to the present bias value to make the bias value equal to the optimum bias value. The calculated bias is the bias to be applied to the PA 106. The bias control through DAC (105) controls the bias applied to the PA 106 by taking the value of the bias determined by the bias calculation block 601 and applies this value to the PA 106. The input signal to the PA 106 is obtained from the WiMAX transceiver 102.

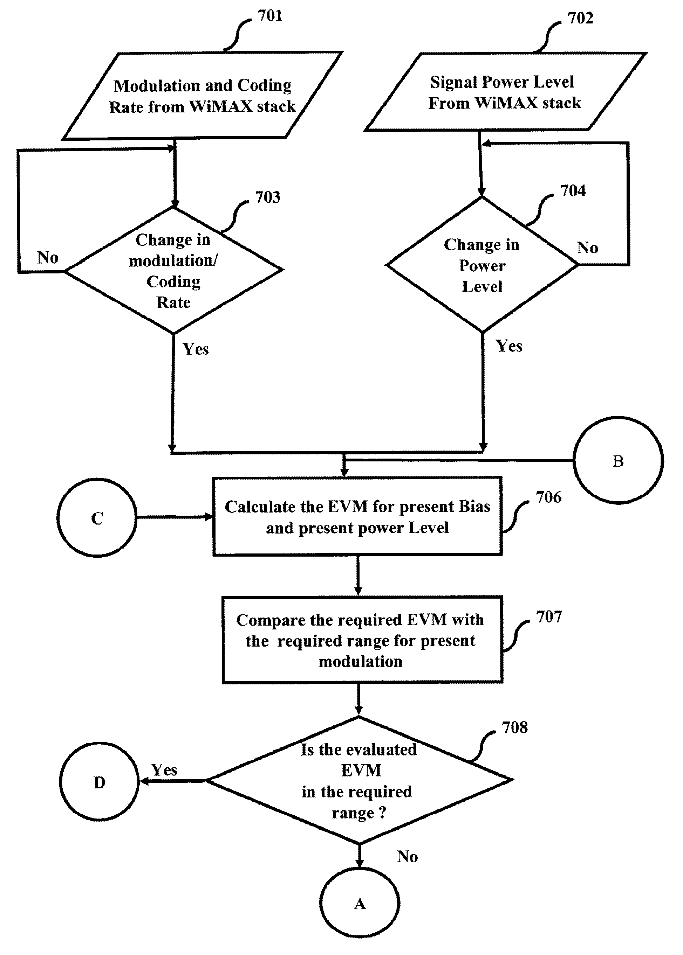

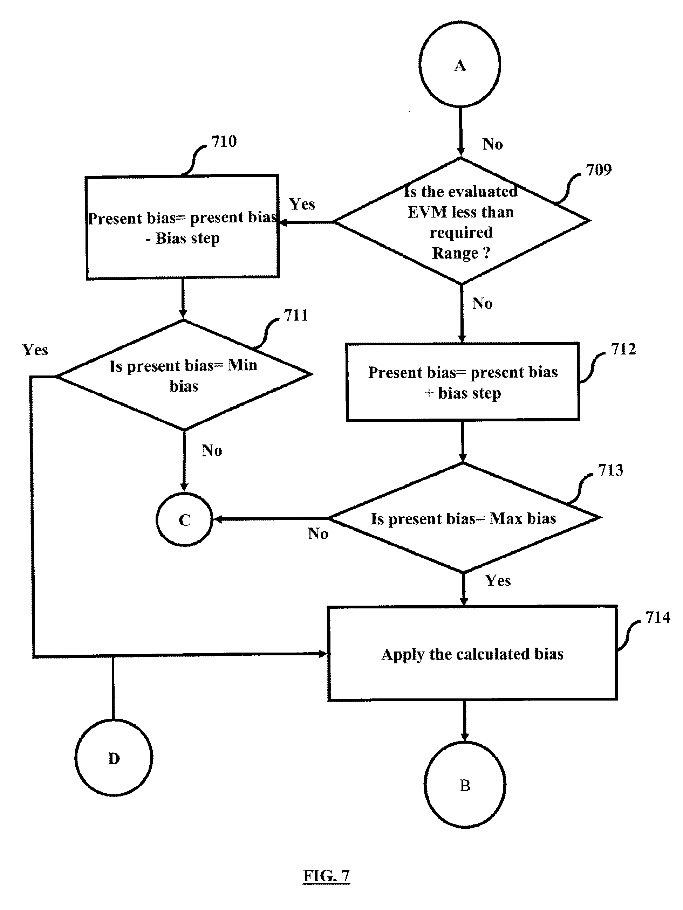

FIG. 7 illustrates a flow chart depicting a method for the mathematical calculation of bias voltage, in accordance with the embodiments herein. The Power Amplifier 106 is evaluated for its Error Vector Magnitude (EVM) performance or the non-linear behavior is modeled a priori to obtain the optimal level of bias for the power amplifier 106. The power amplifier is initially biased to a value equal to maximum bias divided by 2. The transmit power level 702, modulation and coding scheme 701 are recognized from the WiMAX MAC 104. A check is made to detect any change (703) in the modulation scheme or the coding rate. Also, a check is made (704) to detect any change in the transmit power level. If there is any change in the transmit power level and/or modulation scheme or the coding rate the values are fed to the mathematical model in the bias calculation module 301 to check (706) the Error vector Magnitude (EVM) for the present bias voltage. Further the EVM is compared (707) with the required range for the present modulation scheme. A check is made (708) if the evaluated EVM is in the required range. If the EVM is less than the required range then, the new value of present bias is computed (710) by taking the difference of the present bias and the bias step value. Further the present bias value is compared (711) with the minimum bias value; if they are equal the calculated bias is applied (714) to the power amplifier 106. On the other hand if the present bias value is not equal to the minimum bias value it is fed back to the bias calculation module 601 to obtain (706) the new EVM value for the present bias and present power level. Whereas if the EVM is not less than the required range the new value of present bias is computed (712) by adding the present bias value to the bias step. Further the present bias value is compared (713) with the maximum bias value; if they are equal the calculated bias is applied (714) to the power amplifier 106. On the other hand if the present bias value is not equal to the maximum bias value it is fed back to the bias calculation module 601 to obtain (706) the new EVM value corresponding to the present bias and present power level. The various actions in method 700 may be performed in the order presented, in a different order or simultaneously. Further, in some embodiments, some actions listed in FIG. 7 may be omitted.

In another embodiment of the invention the bias determination block 103 determines the bias to be applied to the PA 106. Bias determination block 103 may be realized using a look up module 301 or by a bias calculation block 601. The evaluation of PA 106 takes into consideration variation of EVM for different modulation schemes.

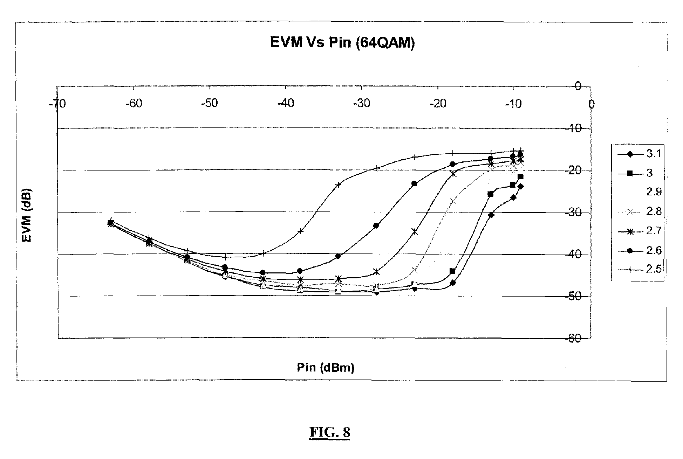

FIG. 8 is a graph illustrating the variation of EVM with PA Radio Frequency (RF) input power at different biasing points for 64 Quadrature Amplitude Modulation (QAM), in accordance with the embodiments herein. Wherein X axis gives variation of Pin and Y axis gives variation of EVM. In QAM modulation scheme the data is sent by changing the amplitude of two carrier waves. The number of points in the grid is usually a power of 2 such as 16QAM, 64QAM, 128QAM so on. Further it is observed that EVM always becomes better for higher biasing for a given power level and modulation scheme. For a given biasing and modulation scheme EVM takes a bath tub shape. In other words EVM is high at very low power levels as well as at very high power levels.

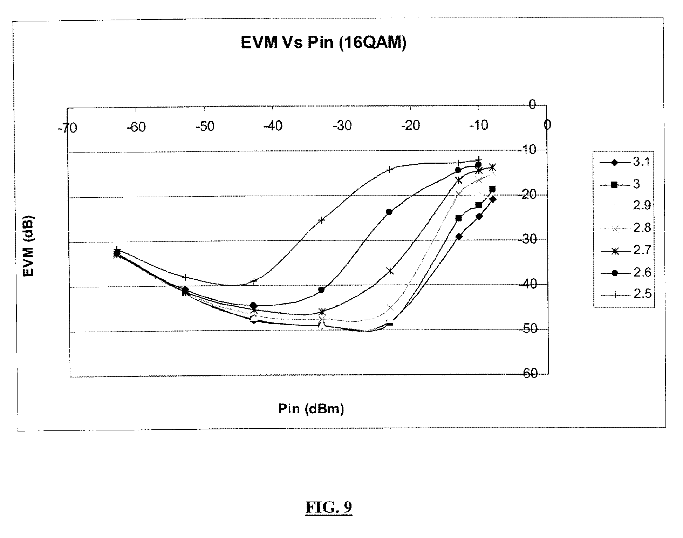

FIG. 9 is a graph illustrating the variation of EVM with PA RF input power at different biasing points for 16QAM, in accordance with the embodiments herein. Wherein X axis gives variation of Pin and Y axis gives variation of EVM. In QAM modulation scheme the data is sent by changing the amplitude of two carrier waves. The number of points in the grid varies as power of 2 and it is 16 in 16QAM scheme. Further it is observed that EVM always becomes better for higher biasing for a given power level and modulation scheme. For a given biasing and modulation scheme EVM takes a bath tub shape. In other words EVM is high at very low power levels as well as at very high power levels

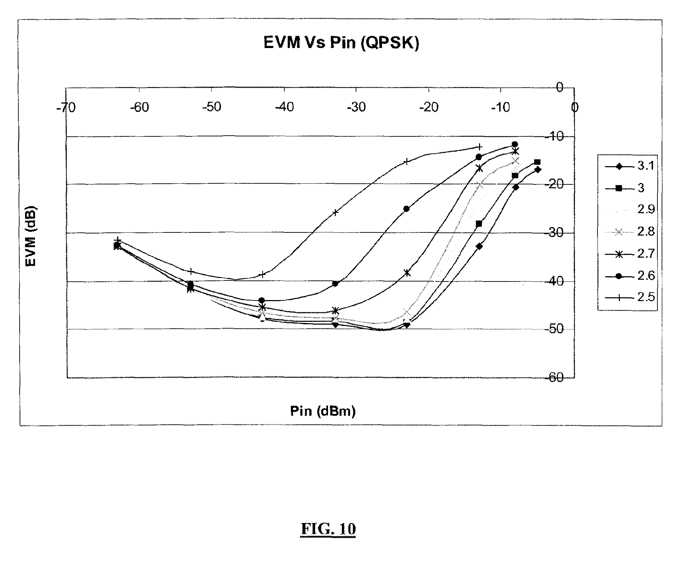

FIG. 10 is a graph illustrating the variation of EVM with PA RF input power at different biasing points for Quadrature Phase-shift Keying (QPSK), in accordance with the embodiments herein. Wherein X axis gives variation of Pin and Y axis gives variation of EVM. In PSK data is conveyed by modulating the phase of the carrier wave. In case of QPSK modulation scheme it uses all four phases for modulation. Further it is observed that EVM always becomes better for higher biasing for a given power level and modulation scheme. For a given biasing and modulation scheme EVM takes a bath tub shape. In other words EVM is high at very low power levels as well as at very high power levels

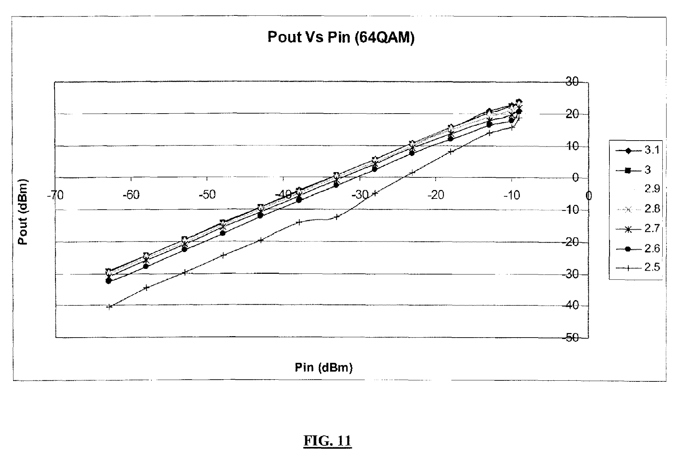

FIG. 11 is a graph illustrating the variation of Power output with PA RF input power at different biasing points for 64QAM, in accordance with the embodiments herein. Wherein X axis gives the variation of Pin and Y axis gives the variation of Pout.

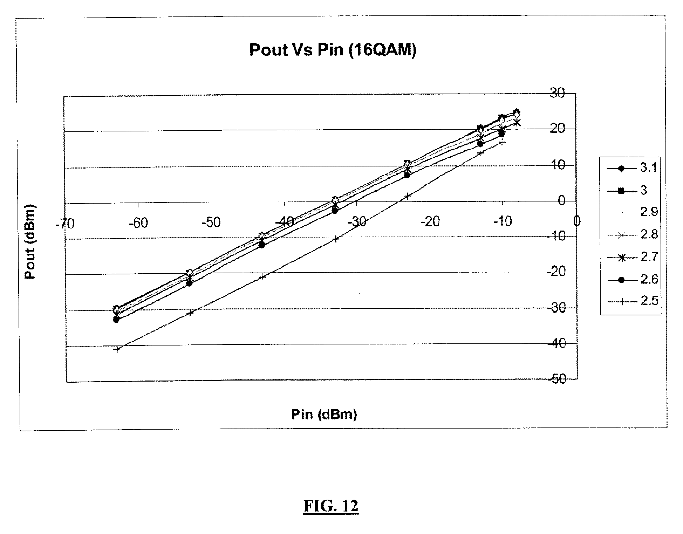

FIG. 12 is a graph illustrating the variation of Output Power with PA RF input power at different biasing points for 16QAM, in accordance with the embodiments herein. Wherein X axis gives the variation of Pin and Y axis gives the variation of Pout.

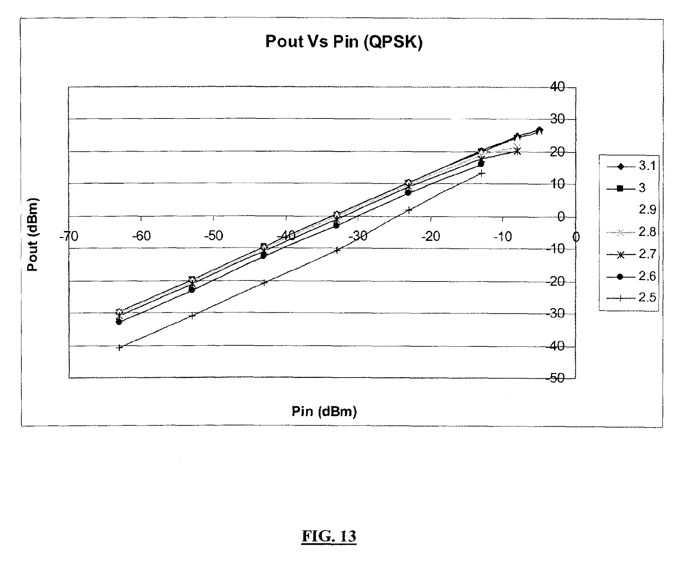

FIG. 13 is a graph illustrating the variation of Output Power with PA RF input power at different biasing points for QPSK, in accordance with the embodiments herein. Wherein X axis gives the variation of Pin and Y axis gives the variation of Pout.

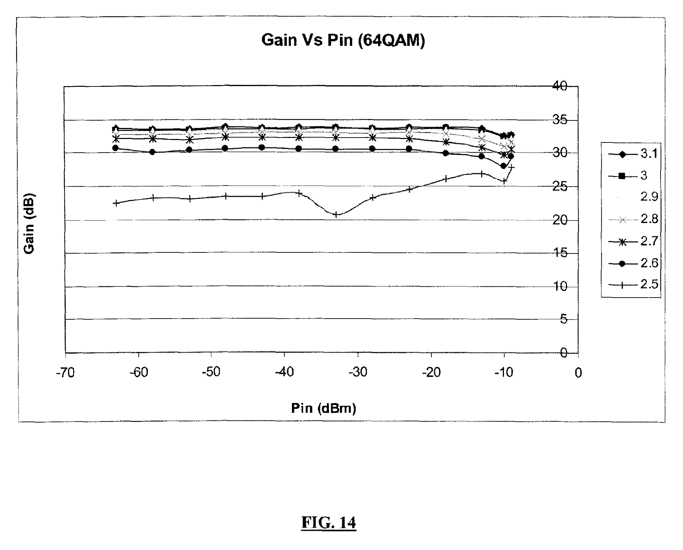

FIG. 14 is a graph illustrating the variation of Gain with PA RF input power at different biasing points for 64QAM, in accordance with the embodiments herein.
Wherein the X axis shows the variation of Pin and the Y axis shows variation of Gain. Further it is observed that the power amplifier shows linear performance up to around - 10dBm of input power and gain reduces for lower biasing points.

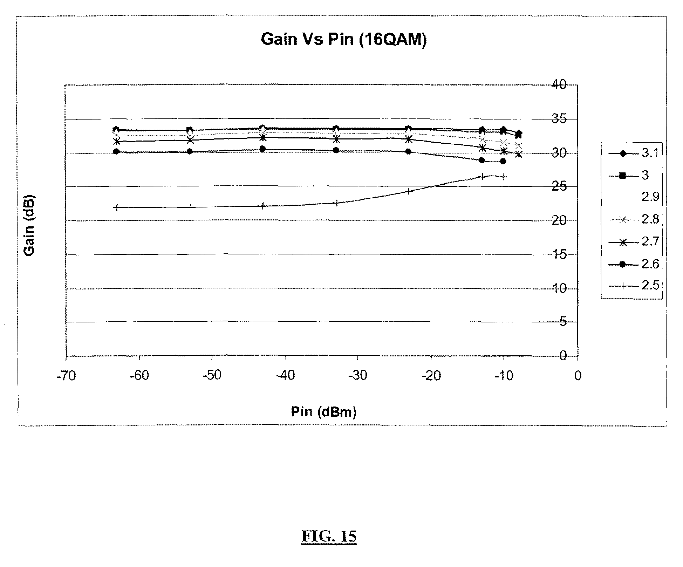

FIG. 15 is a graph illustrating the variation of Gain with PA RF input power at different biasing points for 16QAM, in accordance with the embodiments herein. Wherein the X axis shows the variation of Pin and the Y axis shows variation of Gain. Further it is observed that the power amplifier shows linear performance up to around - 10dBm of input power and gain reduces for lower biasing points.

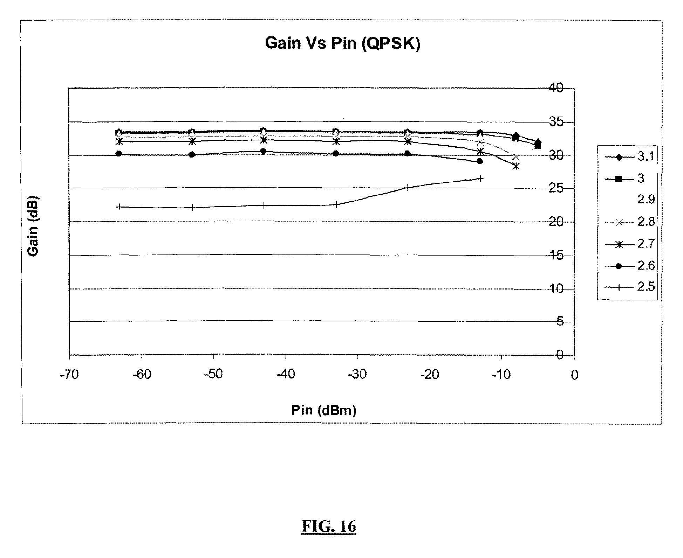

FIG. 16 is a graph illustrating the variation of Gain with PA RF input power at different biasing points for QPSK, in accordance with the embodiments herein. Wherein the X axis shows the variation of Pin and the Y axis shows variation of Gain. Further it is observed that the power amplifier shows linear performance up to around -10dBm of input power and gain reduces for lower biasing points.

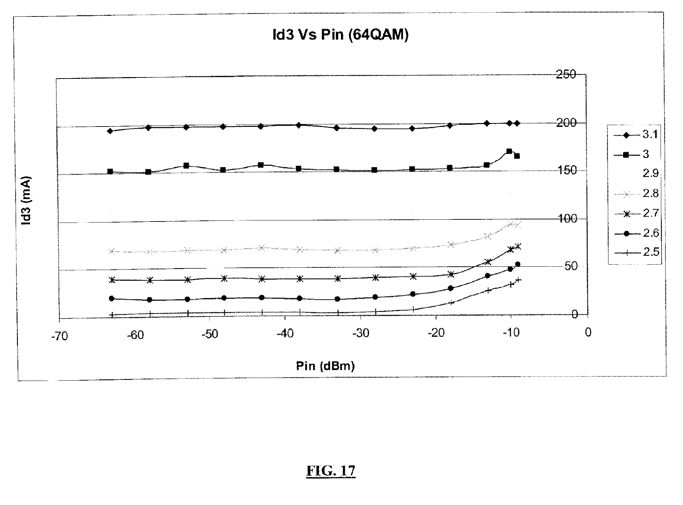

FIG. 17 is a graph illustrating the variation of DC Current Consumption with PA RF input power at different biasing points for 64QAM, in accordance with the embodiments herein. Wherein the X axis shows the variation of Pin and Y axis shows the variation of DC current consumption.

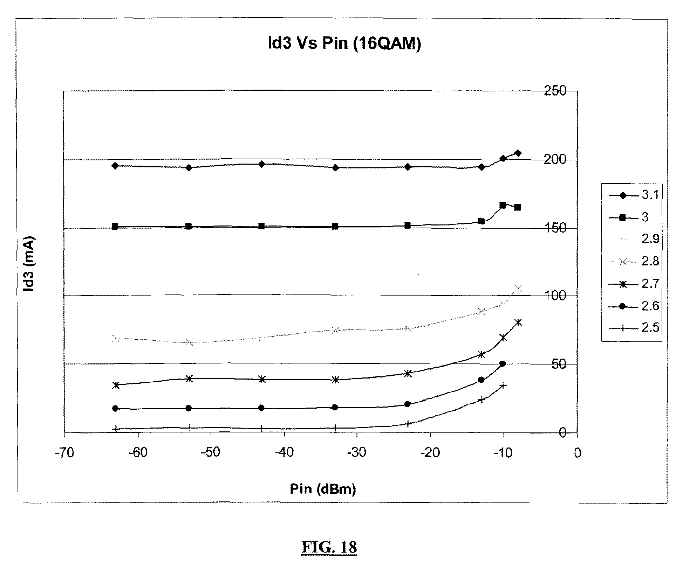

FIG. 18 is a graph illustrating the variation of DC Current Consumption with PA RF input power at different biasing points for 16QAM, in accordance with the embodiments herein. Wherein the X axis shows the variation of Pin and Y axis shows the variation of DC current consumption.

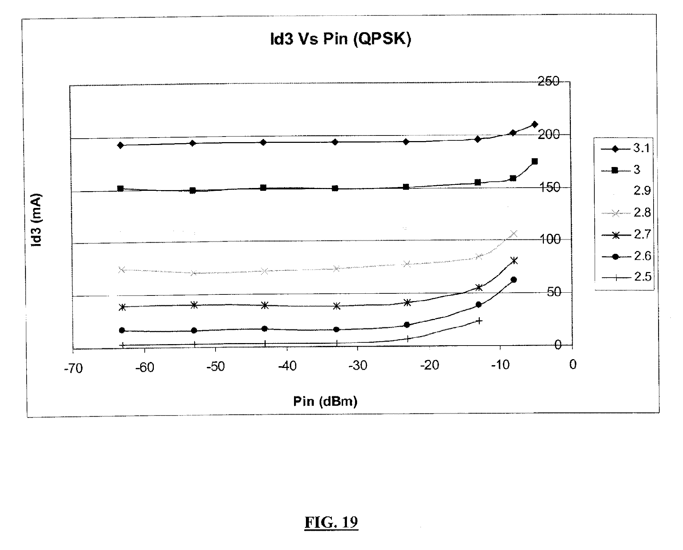

FIG. 19 is a graph illustrating the variation of DC Current Consumption with PA RF input power at different biasing points for QPSK, in accordance with the embodiments herein. Wherein the X axis shows the variation of Pin and Y axis shows the variation of DC current consumption.

The PAs usually have multiple amplification stages. Out of these stages, usually the final stage consumes bulk of the power. Hence, in order to reduce power consumption of the PA considerably, it is usually sufficient to control the bias of the high-power stage(s). This is done by biasing PA final stage adaptively for different power levels and MCS. In this embodiment, adaptive biasing of the PA means adaptively biasing the high-power stage(s) of the PA.

The implementation of the Adaptive bias algorithm calls for both hardware and software support. Basic hardware requirements are that, the selected PA should support variation in bias. Also, the embedded processor should be able to control this bias through software, typically through a DAC. The detailed measurements on the PA for various parameters such as modulation, coding rates, biasing levels or input power levels can be carried out either manually or using a automation process.. The embedded processor executes the program to select the optimal bias voltage from lookup table stored in memory.

Therefare, it is understood that the scope of the protection is extended to such a program and in addition to a computer readable means having a message therein, such computer readable storage means contain program code means for implementation of one or more steps of the method, when the program runs on an embedded processor or any suitable programmable device. The method is implemented in a preferred embodiment through or together with a software program using assembly level languages or using another programming language, being executed on at least one hardware device. The hardware device can be any kind of device which can be programmed including e.g. any kind of computer like a server or a personal computer, an FPGA, a processor, or the like, or any combination thereof, e.g. one processor and two FPGAs. The device may also include means which could be e.g. hardware means like e.g. an ASIC, or a combination of hardware and software means, e.g. an ASIC and an FPGA, or at least one microprocessor and at least one memory with software modules located therein. Thus, the means are at least one hardware means and/or at least one software means. The method embodiments described herein could be implemented in pure hardware or partly in hardware and partly in software. The device may also include only software means. Alternatively, the invention may be implemented on different hardware devices, e.g. using a plurality of CPUs.

## Claims

1. A method of reducing power consumption of power amplifiers in wireless communication systems, said method comprising steps of:
(a) identification (201) of stages of said power amplifiers, wherein said stages consume maximum power supplied to said power amplifier;
(b) determination (202) of corresponding bias voltages of said stage(s) of said power amplifiers;
(c) checking (203) Error Vector Magnitude (EVM) for present bias and present input signal power levels of said power amplifiers;
(d) Determining (206) optimal bias voltage for required modulation and coding scheme for said power amplifiers; and
(e) biasing (207) said power amplifier with said optimal bias voltage.

2. The method, as claimed in claim 1, wherein step (d) further comprises steps of:
evaluating (706) said EVM values for said present bias and said input signal power level;
comparing (707) said evaluated EVM values with required values for present modulation and coding scheme;
checking (708) if said evaluated EVM value is within specified range of values for given modulation and coding scheme; and
calculating (712) said optimal biasing voltage if said evaluated EVM value is not within said required range.

3. The method as claimed in claims 1 to 2, wherein said mathematical model can be modeled using mathematical equations through curve fitting.

4. The method as claimed in claims 1 to 2, wherein said mathematical model evaluates said EVM values for at least one of
said input signal power levels to said power amplifier; and
modulation and coding schemes at different biasing points.

5. The method as claimed in claim 1, wherein step (d) further comprises steps of
preparing said optimum bias voltage table for said power amplifier;
loading look up tables to memory; and
looking up (406) said optimal bias voltage values for said modulation and coding scheme and said present signal power level for corresponding said EVM.

6. A system for reducing power consumption of power amplifiers in wireless communication systems, said system comprising of:
an identification means to identify (201) stages of said power amplifiers, wherein said stages consume maximum power supplied to said power amplifier;
a first determination means to determine (202) corresponding bias voltages of said stage(s) of said power amplifiers;
an evaluation means to evaluate (203) Error Vector Magnitude (EVM) for present bias and signal power level of said power amplifiers;
a second determination means to determine (206) optimal bias voltage for required modulation and coding scheme for said power amplifiers; and
a biasing means to bias (207) said power amplifier with said optimal bias voltage

7. The system claimed in claim 6, said second determination means comprises of:
a measuring means to measure (706) said EVM values for said present bias and said input signal power level;
a comparing means to compare (707) said evaluated EVM values with required values for present modulation and coding scheme;
a checking means to check (708) if said evaluated EVM value is within said required values for said modulation and coding scheme; and
a calculating means to calculate (710), (711), (712) and (713) said optimal biasing voltage if said evaluated EVM value is not within said required modulation and coding scheme.

8. The system as claimed in claims 6 to 7, wherein said evaluation means adapted to evaluate said EVM values for one of
said input signal power levels to said power amplifier; and
modulation and coding schemes at different biasing points;

9. The system as claimed in claim 6, said evaluation means comprises of
a preparation means to prepare said optimum bias voltage table for said power amplifier;
a loading means to load said look up tables into a memory; and
a looking up (406) means to check said optimal bias voltage values for said present bias and said present signal power level in said look up tables for corresponding said EVM.
